Europäisches Patentamt

European Patent Office

Office européen des brevets

(11) Publication number: **0 235 985**
**A2**

(12) **EUROPEAN PATENT APPLICATION**

(21) Application number: 87301230.6

(22) Date of filing: 12.02.87

(51) Int. Cl.4: **G01R 29/00**

(30) Priority: 05.03.86 GB 8605368

(43) Date of publication of application:
09.09.87 Bulletin 87/37

(84) Designated Contracting States:
DE ES FR IT NL

(71) Applicant: **UNITED KINGDOM ATOMIC ENERGY AUTHORITY**
**11 Charles II Street**
**London SW1Y 4QP(GB)**

(72) Inventor: **Clayton, Colin Geoffrey**
**Argoed Hall Tregaron**
**Dyfed SY25 6JR Wales(GB)**
Inventor: **Spackman, Ramon**
**Hunters Moon Upton**
**Didcot Oxfordshire OX11 9HT(GB)**

(74) Representative: **Mansfield, Peter Turquand**
**United Kingdom Atomic Energy Authority**
**Patents Branch 11 Charles II Street**
**London SW1Y 4QP(GB)**

(54) **Data processing.**

(57) A method and an apparatus are provided for processing data consisting of a signal and noise where both signal and noise consist of a series of pulses at random intervals, so as to detect the signal, applicable even where the signal is almost submerged within the noise. The pulses are passed through a time gate (26) arranged to accept only those pulses for which the preceding time interval is less than the average for the noise pulses alone. Successive pulses may be processed in one of a number of parallel channels (24), each including such a time gate, and the numbers of accepted pulses in each channel combined in unit time periods to give an output signal, which may undergo further processing such as passage through an amplitude gate (32).

Fig.1.

## Data Processing

This invention relates to a method and an apparatus for processing data, in particular for detecting a signal in the presence of noise where both the signal and the noise consist of series of pulses at random intervals.

Such data is characteristic of that produced by radioactive decay. For example lumps of ore or rock may be sorted by neutron activation of a desired element and subsequent detection of radiation emitted from the lumps as the activated atoms decay. In this case the desired signal is that from the decay of the activated atoms, but there is also a background noise due for example to naturally radioactive atoms in the environment. Another example is the measurement of fluid flow velocity in a pipe by injection of a radioactive tracer into the fluid, and subsequent detection of radiation from the tracer, and in this case too there will be noise due to background radiation. In each case, advantages accrue the smaller the signal which can be detected; in the first case less irradiation will be needed, or a lower concentration of the desired element can be detected; in the second case less tracer need be injected, or the tracer can be detected at a greater distance from the point of injection.

According to the present invention there is provided a method of processing data to detect a signal in the presence of noise, where both the signal and the noise consist of series of pulses and at least the noise pulses occur at random intervals, comprising time-gating the pulses and accepting only those pulses for which the corresponding time interval is less, by a predetermined factor, k, than the mean time interval for the noise pulses alone.

For example the accepted pulses might be those for which the corresponding time interval is less than a third of the said mean time interval.

In a case where a parameter of a flowing liquid is to be determined, for example the measurement of flow velocity by the injection of a radioactive tracer, those atoms from which the signal is to be received will diffuse through the liquid so that a portion of the liquid containing such atoms, initially sharply defined, will spread out as the liquid flows. This spreading out will occur to a greater extent if the liquid flow is turbulent. It is clearly important that the data processing method does not itself change the value of the detected parameter, which is usually the arrival time of the centre of area of the signal trace.

In such a situation, it is preferable to fold the data before processing it as set out above, i.e. to carry out the process in n parallel channels, successive pulses being processed by different channels so that each channel processes only every nth pulse, where n is a positive integer greater than one. As n is increased, the closer does the most probable interval in each channel get to the average interval between pulses in each channel, which is what is required to maintain the position of the centre of area of the trace. In practice the use of a large value of n is not possible unless the signal to be detected consists of a very large number of pulses.

The accepted pulses in each channel may then be combined to give the count rate of accepted pulses in successive unit time periods (for example one second intervals), and these values of count rate may be subjected to an amplitude gate. In calculating values of count rate, weighting of the accepted pulses may be performed either in accordance with the shortness of the corresponding time intervals or in accordance with the proximity to other accepted pulses.

The invention also provides a data processing apparatus for processing a series of pulses in the manner described above.

The invention will now be described in greater detail, by way of example only, and with reference to the accompanying drawings, in which:

Figure 1 shows a diagrammatic circuit diagram of fluid flow measuring apparatus incorporating a data processing apparatus of the invention; and

Figures 2 (a), (b), (c) and (d) are graphical representations of variations of count rate with time for a series of pulses.

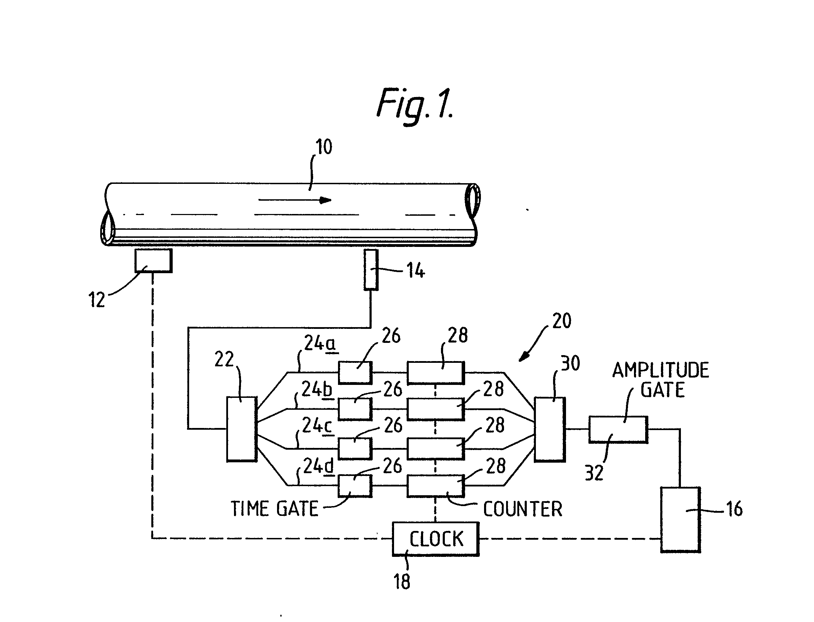

Referring to Figure 1, there is shown an apparatus for measuring the flow velocity of a fluid in a pipe 10, the apparatus comprising a pulsed neutron source 12 for activating atoms within the fluid, and a gamma radiation sensor 14 arranged next to the pipe, spaced along in the direction of flow from the source 12, for detecting gamma rays emitted by the activated atoms. The sensor 14 produces an electrical pulse for every gamma ray detected by it, and these pulses are supplied to a velocity calculating device 16 through a data processing apparatus 20. Operation of the pulsed neutron source 12 and the velocity calculating device 16 are synchronised by a clock 18.

In operation of the apparatus, at time zero the source 12 emits a neutron pulse which activates atoms within the fluid. When the activated atoms, carried along in the fluid, reach the vicinity of the sensor 14 and emit gamma rays, these are detected by the sensor 14 and corresponding signal pulses will be produced. The signal trace will be approximately Gaussian in shape (due to diffusion of the activated atoms and non-uniform velocity of, and/or turbulence in, the fluid); the time at which the centre of area of the signal trace occurs indicates the time taken by the fluid to flow from the source 12 to the sensor 14, from which the flow velocity can readily be determined.

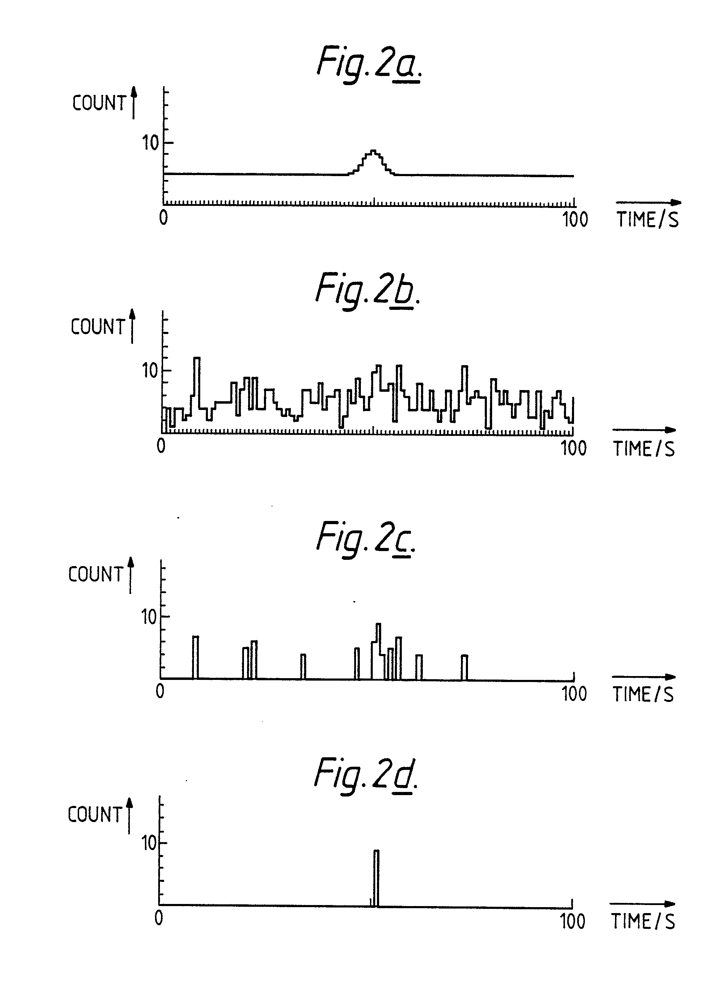

The sensor 14 will also produce pulses at other times, due to gamma radiation from the environment or from naturally radioactive atoms within the fluid, and these pulses constitute noise above which the signal trace must be detected. This is straightforward if the signal is much greater than the noise, but much more difficult if the signal is less than or comparable to the noise. Referring to Figures 2a and b, these show graphically the counts i.e. the numbers of pulses, in one hundred consecutive one-second time periods, for a situation where the noise is on average five counts per second, and a signal trace is centred on the fiftieth time period with a total of twenty counts and a standard deviation of two seconds. Figure 2a shows an idealised (and totally unrealistic) graph in which the noise is constant; whereas Figure 2b shows the same situation but with all the pulses occurring at random intervals, as happens in practice. (If the situation represented in Figure 2b were to be repeated sufficiently many times, the average counts for each time period would be as shown in Figure 2 a.)

Referring again to Figure I, the data processing apparatus 20 comprises a shift register 22 to which the pulses from the sensor 14 are supplied, and which has four output terminals connected to four identical parallel channels 24a, b , c and d. Each successive pulse from the sensor 14 causes a corresponding pulse to be supplied to one of the channels 24a to d, pulses being supplied to each channel in turn, so that any one channel 24a, b, c or d receives a pulse corresponding to every fourth pulse from the sensor 14. Each channel comprises a time gate 26 to which the pulses in that channel are supplied and which is set to accept only those pulses within a preset time after the preceding pulse in that channel, this preset time being less than the average time between pulses. In this embodiment the expected average time interval between noise pulses from the sensor 14 is 0.2 seconds, and since there are four channels the average time interval between pulses in any one channel is 0.8 seconds. Each time gate 26 is set to accept pulses occurring within 0.5 seconds of the preceding pulse. Each channel 24a to d also includes a counter 28 arranged to count the number of pulses accepted by the time gate 26 during successive one-second time periods, all the counters 28 being synchronised by the clock 18, and at the end of each time period to supply a signal representing the count to an adder 30, the adder 30 receiving the signals from all four counters 28.

The adder 30 generates a signal representing the sum of the signals from the counters 28, this signal being passed through an amplitude gate 32 to the input of the velocity calculating device 16. Referring to Figures 2c and 2d, these correspond to the situation described above in relation to Figure 2 b; Figure 2 c shows the counts in one hundred successive time intervals after the pulses have passed through the time gates 26 of the channels 24, and represents the output signal from the adder 30, while Figure 2 d represents the output signal from the amplitude gate 32. The amplitude gate 32 is set to accept only those signals of amplitude greater than seven counts. It will be observed that in this situation the signal received by the velocity calculating device 16 indicates the centre of the signal trace (as shown in Figure 2 a), at least to an accuracy of a couple of seconds.

It will be appreciated that the apparatus 20 may be modified in various ways while remaining within the scope of the invention. For example the channels 24 a to d might be arranged to give an output count to the adder 30 weighted towards shorter time intervals - as described above all pulses occurring within 0.5 seconds of the preceding pulse produce a count of one, but, additionally, any pulse occurring within say 0.25 seconds of the preceding pulse might produce a count of two and any pulse occurring within say 0.16 seconds of the preceding pulse might produce a count of three. An alternative method of weighting would be to arrange the output from the counter 28, rather than being equal to the number of accepted pulses, m, within a time period, to equal an increasing function of m, for example $(2^{m}-1)$, so being weighted towards short time intervals occurring in proximity.

It will also be understood that, in the apparatus 20 described above the four separate counters 28 could be replaced by a single counter to which the accepted pulses from all four time gates 26 would be supplied, in which case no adder 30 is required. Furthermore the number of channels 24 to which the pulses are supplied might be different from that described. Especially where the data processing apparatus 20 is to be used in situations where preservation of the centre of area of the signal trace is not required, as for example ore sorting, only one such channel 24 need be provided, to which all the pulses from the sensor 14 would be supplied, so the shift register 22 is not required.

It will also be appreciated that the settings of the time gates 26 and of the amplitude gate 32, and the duration of the time periods for which the counters 28 determine the number of accepted pulses, might differ from the values stated above. The apparatus might additionally include means to record the electrical pulses from the sensor 14, so that they can be processed more than once with different settings of these parameters. The setting of the amplitude gate 32 might be gradually increased until only one pulse is accepted. The centre of the signal trace can also be located by determining the mid-point of the sequence of consecutive non-zero output signals from the adder 30 which includes the largest output signal as determined by the amplitude gate 32.

## Claims

1. A method of processing data to detect a signal in the presence of noise, where both the signal and the noise consist of series of pulses and at least the noise pulses occur at random intervals, characterised by time-gating the pulses and accepting only those pulses for which the corresponding time interval is less, by a predetermined factor $k$, than the mean time interval for the noise pulses alone.

2. A method of processing data as claimed in Claim 1 wherein the method is performed in n parallel channels (24), successive pulses being processed by different channels (24), so that each channel (24) processes only every nth pulse, where n is a positive integer greater than one.

3. A method of processing data as claimed in Claim 1 or Claim 2 further including determining the count of accepted pulses in successive unit time intervals, wherein the accepted pulses are weighted either in accordance with the shortness of the corresponding time intervals or in accordance with the proximity to other accepted pulses.

4. A method of processing data as claimed in any one of the preceding Claims and including determining the count of accepted pulses in successive unit time intervals, wherein the method also includes determining that time interval for which the said count is greatest.

5. A method of processing data as claimed in Claim 4 further including determining the time corresponding to the mid-point of that sequence of consecutive non-zero said counts which includes said greatest count.

6. A data processing apparatus for detecting a signal in the presence of noise, where both the signal and the noise consist of series of pulses and at least the noise pulses occur at random intervals, characterised by including a time gate (26) for the pulses set to accept only those pulses for which the corresponding time interval is less, by a predetermined factor $k$, then the mean time interval for the noise pulses alone.

Fig.1.

Fig.2a.

Fig.2b.

Fig.2c.

Fig.2d.